# EUROPEAN PATENT SPECIFICATION

(11) **EP 0 366 082 B1**
(45) Date of publication and mention of the grant of the patent: **10.04.1996**
(21) Application number: 89119744.4
(22) Date of filing: 24.10.1989
(51) Int. Cl.: H01L 23/373

(54) **Member for carrying semiconductor device**
Träger für eine Halbleiteranordnung
Support pour dispositif semi-conducteur

(30) Priority: 28.10.1988 JP 273965/88; 31.10.1988 JP 276564/88
(43) Date of publication of application: 02.05.1990
(73) Proprietor: SUMITOMO ELECTRIC INDUSTRIES, LTD., Osaka-shi, Osaka 541 (JP)
(72) Inventor: Hanada, Masazumi c/o Itami Works of Sumitomo, Itami-shi Hyogo-ken (JP); Takeda, Yoshinobu c/o Itami Works of Sumitomo, Itami-shi Hyogo-ken (JP)
(74) Representative: Herrmann-Trentepohl, Werner, Dipl.-Ing.

(56) References cited:
- EP-A- 0 057 085
- EP-A- 0 117 352
- EP-A- 0 181 416
- EP-A- 0 183 016
- EP-A- 0 233 824
- PATENT ABSTRACTS OF JAPAN, vol. 12, no. 101 (E-595)[2948], 2nd April 1988; & JP-A-62 232 943 (SUMITOMO ELECTRIC) 13-10-1987
- IDEM
- PATENT ABSTRACTS OF JAPAN, vol. 8, no. 74 (E-236), 6th April 1984; & JP-A-58 223 349 (FUJITSU) 24-12-1983

## Description

### Member for Carrying Semiconductor Device

### BACKGROUND OF THE INVENTION

### Field of the Invention

The present invention relates to a member for a semiconductor device such as a radiation member or a package employed for various semiconductor integrated circuit (IC) devices or the like, and more particularly, it relates to an aluminum alloy member for a semiconductor device, which has low thermal expansion and other characteristics.

### Description of the Background Art

A material forming a substrate for a semiconductor device must have a thermal expansion coefficient which is substantially similar to that of the semiconductor device, so that no distortion is caused by thermal stress. Thus, a material having small difference in thermal expansion coefficient has been generally prepared from an Ni alloy such as ASTM F-15 (29 wt.% Ni - 17 wt.% Co - Fe) or ASTM F-30 (42 wt.% Ni - Fe), or a ceramic material such as alumina or forsterite.

In recent years, however, the semiconductor technique has been remarkably improved to cause increase in scale and circuit density of semiconductor devices. Thus, a problem of heat dissipation has come into question in addition to the aforementioned difference in thermal expansion coefficient. In other words, not only small difference in thermal expansion coefficient but excellent heat dissipation is required as the semiconductor devices are increased in scale and circuit density.

Under such circumstances, beryllia, tungsten, molybdenum or the like has been generally proposed as a material which satisfies both of the above characteristics.

However, beryllia, which is toxic, is practically unemployable in consideration of health hazard and environmental pollution.

On the other hand, molybdenum and tungsten are very expensive since these elements are produced in a few area in the world in small amounts. Thus, employment of such metal materials leads to increase in cost for the semiconductor devices. Besides, such metals are heavy because of relatively high density (19.3 g/cm³ in tungsten and 10.2 g/cm³ in molybdenum), while the same are relatively hard to machine.

Thus, awaited is a lightweight substrate material for a semiconductor device, which can satisfy both of the required characteristics of excellent heat dissipation and small difference in thermal expansion coefficient with excellent machinability.

Japanese Patent Publication No. 63-16458(1988) discloses an aluminum alloy prepared by adding 30 to 50 percent by weight of silicon to aluminum, as such a substrate material for a semiconductor device.

However, although the aforementioned alloy of Al - 30 to 50 wt.% Si has a thermal expansion coefficient which is substantially similar to that of a semiconductor element, heat dissipation thereof is reduced as compared with that of an ordinary aluminum alloy containing a small amount of silicon. In general, it has been possible to cope with heat generation in a semiconductor device even if heat dissipation of the aluminum alloy is reduced. As to a higher heating value following high integration of a recent semiconductor element, however, it is difficult to sufficiently dissipate heat generated in the semiconductor element by a radiation member formed of only the aforementioned Al-Si alloy.

On the other hand, lightness and high reliability of moisture resistance, heat resistance etc. are particularly required for a package employed for a small and lightweight microwave integrated circuit device which is suitable for a mobile radio station such as a communication satellite, an aircraft or the like. In general, the package for a microwave integrated circuit device is prepared from a ferrous material such as stainless steel, iron-nickel 42 % alloy or the like. However, such a ferrous material has relatively large specific gravity of about 8 g/cm³. Therefore, the ferrous material has been unsatisfactory as a package material for a microwave integrated circuit device which is carried on a satellite, an aircraft or the like. When a circuit element is highly integrated and the package is reduced in size and weight, further, the circuit carried on the package is damaged by heat generation since the ferrous material has low thermal conductivity of 0.17 J/°C·cm·sec (0.04 cal/°C·cm·sec).

In order to solve such problems, employment of an aluminum package has been recently studied. However, although a desired value of thermal conductivity can be obtained in a package material prepared from a general aluminum alloy according to Japanese Industrial Standards (JIS) or ASTM, such a material has a high thermal expansion coefficient of at least about 20 x 10⁻⁶/°C, a value which is extremely different from that of a material forming a circuit substrate. When the circuit substrate is directly mounted on the surface of the package by Au-Sn solder or the like, therefore, the circuit substrate is cracked by thermal stress caused by the difference in thermal expansion coefficient. In order to solve this problem, it has been necessary to insert a member having stress relaxation structure between the package and the circuit substrate. As the result, the structure of the package has been complicated.

It may be considered to reduce the thermal expansion coefficient of the aluminum alloy by adding at least 30 percent by weight, for example, of silicon to aluminum so that the content of silicon exceeds that of a general aluminum alloy according to JIS or ASTM. When such an Al-Si alloy is obtained by general casting, however, its machinability is extremely reduced since the particle size of primary silicon crystal is increased. Thus, it is difficult to precisely machine the alloy into a desired configuration required for a package.

Alternatively, the thermal expansion coefficient may be reduced by adding ceramic particles of silicon carbide or the like to aluminum. Also in this case, however, machinability of the alloy is extremely reduced.

When a package is manufactured, members thereof are suitably joined with each other by laser welding, to cause no thermal effect on a microwave integrated circuit device which is previously carried within the case thereof. If a general aluminum alloy according to JIS is subjected to laser welding, however, cracking is caused following quenching since the weld zone is cooled at a higher rate as compared with the base metal. Thus, it is impossible to maintain airtightness of the package. In order to solve this problem, proposed are a method of inserting an Al-Si brazing filler metal between the case and a lid member or performing nickel plating etc. for carrying out a laser welding step to solution-treat nickel and silicon in the weld zone and increase hot strength of the same thereby to prevent cracking as disclosed in Japanese Patent Laying-Open No. 58-22350(1983) or 60-31247(1985), and a method of utilizing a cast aluminum alloy having a high content of silicon as disclosed in Japanese Patent Laying-Open No. 58-223349(1983). However, the former method requires an excessive process for plating or preparation of the brazing filler metal. In the latter method, on the other hand, coarse primary silicon crystallizes as hereinabove described, to prevent precise machine work.

Further, a general aluminum alloy according to JIS has a lower Young's modulus of 7000 to 8000 kgf/mm as compared with a ferrous material such as stainless steel. Therefore, it is necessary to increase the thickness of a case in order to guarantee mechanical strength of a package formed by the general aluminum alloy. Thus, the package cannot be effectively miniaturized.

JP-A-62 232 943 discloses a substrate material for semiconductor device including an aluminum alloy containing 30-to 60 wt.% of Si. The coefficient of thermal expansion of the disclosed aluminum alloy is 18 x 10⁻⁶/°C or below. However, the thermal conductivity of the aluminum alloy disclosed in this reference shows 1.26 J/°C·cm·sec (0.30 cal/°C·cm·sec) as a maximum value of Al-40 wt.% Si alloy.

EP-A-0 057 085 discloses a method of manufacturing a hybrid integrated circuit device using an aluminum plate as a substrate of hybrid integrated circuit device. The substrate is formed by spraying coarse particles of Al₂O₃ onto the surface of a pure aluminum plate.

JP-A-58 223 349 discloses an aluminum package for microwave, which is airtight and comprises a case of an AL-Si group casting Al alloy. The two members are assembled by laser welding.

### SUMMARY OF THE INVENTION

An object of the present invention is to provide a lightweight radiation member for a semiconductor device having excellent machinability, which can satisfy both characteristics of excellent heat dissipation and small difference in thermal expansion coefficient required following increase in heat generation of a semiconductor element.

In order to attain the aforementioned object, the inventors have made deep study to find that it is possible to obtain a radiation member for a semiconductor device which can satisfy both of the characteristics of small difference in thermal expansion coefficient and high heat dissipation by preparing a portion requiring low thermal expansion and a portion requiring high heat dissipation from different aluminum alloys and integrally forming the aluminum alloy portions by hot working.

The inventive radiation member for a semiconductor device comprises a portion of a first aluminum alloy having a major surface for carrying the semiconductor device thereon and a portion of a second aluminum alloy integrally joined/formed with the portion of the first aluminum alloy. The first aluminum alloy has an average thermal expansion coefficient of not more than 17 x 10⁻⁶/°C. The second aluminum alloy is larger in thermal conductivity than the first aluminum alloy.

The first aluminum alloy preferably contains 30 to 60 percent by weight of silicon, and the residual part thereof may be formed of aluminum and unavoidable impurities. The content of silicon is limited to 30 to 60 percent by weight because the thermal expansion coefficient exceeds a desired value if the silicon content is less than 30 percent by weight, while thermal conductivity, powder moldability and hot workability are extremely deteriorated if the silicon content exceeds 60 percent by weight.

The inventive radiation member for a semiconductor device, which is integrally formed by the first aluminum alloy member exhibiting low thermal expansibilty and the second aluminum alloy member exhibiting high heat dissipation, can be provided with high heat dissipation and low thermal expansion as compared with a radiation member which is formed of a conventional aluminum alloy.

The inventors have made deep study to find that it is possible to obtain a package for a microwave integrated circuit device which is satisfactory in thermal expansion coefficient, thermal conductivity and machinability by adding a large amount of silicon to aluminum so that the particle size of primary silicon crystal is not more than 50 µm.

A package, not forming part of the present invention, for a microwave integrated circuit device comprises a container member formed of a first aluminum alloy and a lid member formed of a second aluminum alloy, which members are joined with each other by laser welding and sealed in an airtight manner. The container member has an inner surface for carrying the microwave integrated circuit device thereon, and an opening part for receiving the microwave integrated circuit device therethrough. The first aluminum alloy contains 30 to 60 percent by weight of silicon and its residual part is formed of aluminum and unavoidable impurities, while the particle size of primary silicon crystal is not more than 50 µm. The lid member is provided above the microwave integrated circuit device to protect the same, and adapted to cover/close the opening part of the container member.

The aluminum alloy forming the lid member may preferably be prepared from the same material as that for the aluminum alloy forming the container member. The thermal expansion coefficient of the aluminum alloy forming the container member may be not more than 17 x 10⁻⁶/°C.

The container member having the inner surface for carrying the microwave integrated circuit device thereon is formed of the aluminum alloy containing 30 to 60 percent by weight of silicon, whereby difference in thermal expansion coefficient between the same and a semiconductor element or a circuit substrate forming the microwave integrated circuit device is small. Thus, it is possible to reduce distortion based on thermal stress caused between the microwave integrated circuit device and the container member. Further, it is also possible to prevent damage caused by heat generation of the device carried in the package since the aforementioned aluminum alloy is relatively excellent in heat dissipation.

Further, machinability of the aluminum alloy is not reduced since the particle size of primary silicon crystal is not more than 50 µm. Thus, it is possible to precisely work the aluminum alloy into a desired configuration.

The aluminum alloy containing 30 to 60 percent by weight of silicon contributes to reduction in weight of the package since its density is smaller than that of a general aluminum alloy. Further, the thickness of the container member forming the package can be further reduced since the aforementioned aluminum alloy has a higher Young's modulus as compared with the general aluminum alloy, to also contribute to reduction in weight of the package.

When the container member formed of the aluminum alloy having the aforementioned composition is joined with the lid member by laser welding, the base metal and the weld zone are merely slightly changed in microstructure by rapid solidification after the laser welding since the particle size of primary silicon crystal contained in the aluminum alloy forming the container member is not more than 50 µm. Thus, it is possible to prevent cracking and maintain airtightness of the package.

According to an aspect of the present invention, it is possible to provide a radiation member for a semiconductor device, which is formed by aluminum alloy members and has both characteristics of low thermal expansion and high heat dissipation. Thus, the radiation member is effectively applied to a semiconductor device having high heat generation and requiring high reliability. Further, the inventive radiation member for a semiconductor device can be easily reduced in weight since the same is formed by aluminum alloy members.

It is possible to provide a small and lightweight package for a microwave integrated circuit device, which is sealed in an airtight manner. Thus, the package is effectively employed in the field of an artificial satellite, an aircraft and the like. Further, it is possible to increase the life of a device to be carried on the inventive package and improve reliability thereof since the package can reduce distortion caused by thermal stress and has excellent thermal dissipation. It is also possible to reduce the manufacturing cost since the package can be reduced in weight and has excellent machinability.

As hereinabove described, the inventive member for carrying a semiconductor device comprises at least a portion of a first aluminum alloy having a major surface for carrying the semiconductor device thereon and a portion of a second aluminum alloy. The first aluminum alloy has an average thermal expansion coefficient of not more than 17 x 10⁻⁶/°C. The portion of the second aluminum alloy is joined to the portion of the first aluminum alloy. Thus, it is possible to at least reduce by the first aluminum alloy distortion based on thermal stress caused between the semiconductor device and the inventive member. The second aluminum alloy portion, which is joined to the portion of the first aluminum alloy, can be formed in accordance with other required characteristics such as heat dissipation responsive to the calorific power of the semiconductor device, for example.

These and other objects, features, aspects and advantages of the present invention will become more apparent from the following detailed description of the present invention when taken in conjunction with the accompanying drawings.

### BRIEF DESCRIPTION OF THE DRAWINGS

Figs. 1A and 1B are partially fragmented sectional views showing an exemplary method of manufacturing a radiation member for a semiconductor device according to the present invention;
Fig. 2 is a perspective view showing an embodiment of the inventive radiation member for a semiconductor device which is obtained by the manufacturing method shown in Figs. 1A and 1B;
Figs. 3A, 3B and 3C are partially fragmented sectional views showing another exemplary method of manufacturing a radiation member for a semiconductor device according to the present invention;
Fig. 4 is a perspective view showing another embodiment of the inventive radiation member for a semiconductor device obtained by the manufacturing method shown in Figs. 3A to 3C;
Fig. 5 is a partially fragmented sectional view showing still another exemplary method of manufacturing a radiation member for a semiconductor device according to the present invention;
Fig. 6 is a perspective view showing still another embodiment of the inventive radiation member for a semiconductor device obtained by the manufacturing method shown in Fig. 5;
Fig. 7 is a partially fragmented sectional view showing a further exemplary method of manufacturing a radiation member for a semiconductor device according to the present invention;
Fig. 8 is a perspective view showing a further embodiment of the radiation member for a semiconductor device obtained by the manufacturing method shown in Fig. 7;
Fig. 9 is a sectional view showing an exemplary IC package into which the radiation member for a semiconductor device shown in Fig. 2 is integrated;
Fig. 10 is a sectional view showing another exemplary IC package into which the radiation member for a semiconductor device shown in Fig. 4 is integrated;
Fig. 11 is a sectional view showing an exemplary metal package into which the radiation member for a semiconductor device shown in Fig. 8 is integrated;
Fig. 12 is a schematic perspective view showing a package for a microwave integrated circuit; and
Fig. 13 is a schematic sectional view showing a method of laser welding for joining a lid and a case for manufacturing the package shown in Fig. 12.

### DESCRIPTION OF THE PREFERRED EMBODIMENTS

Embodiments of the present invention are now described with reference to the drawings.

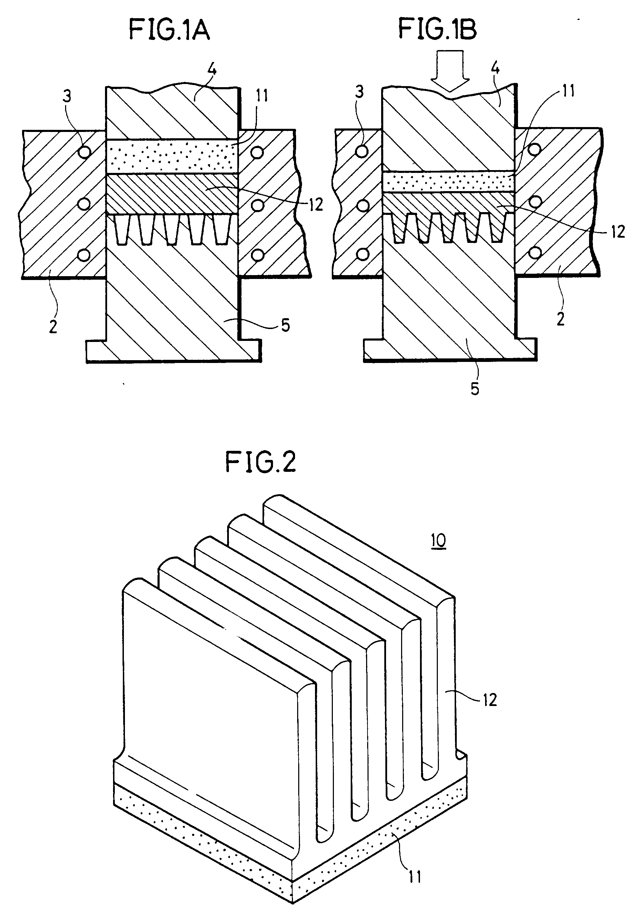

Figs. 1A and 1B are partially fragmented sectional views showing an exemplary method of manufacturing a radiation member according to the present invention. Referring to Fig. lA, a high radiation aluminum alloy member 12 formed of an aluminum alloy of JIS or ASTM nominal No. 1100, for example, is forced into a clearance defined between dies 2, which are heated to a temperature of 400°C by heating elements 3, and a lower punch 5. Further, quench-solidified powder composed of Al - 40 wt.% Si, for example, is charged on the high radiation aluminum alloy member 12, thereby to form a low thermal expansion aluminum alloy member 11. Thereafter the aluminum alloy members 11 and 12 are pressurized by an upper punch 4 and the lower punch 5 along the arrow shown in Fig. 1B, so that parts of the high radiation aluminum alloy member 12 fill up slit-type grooves which are defined in the upper surface of the lower punch 5, to be formed into radiation fins. At the same time, the powder of Al - 40 wt.% Si forming the low thermal expansion aluminum alloy member 11 is solidified to cause diffused junction at the interface between the same and the high radiation aluminum alloy member 12, so that the aluminum alloy members 11 and 12 are integrated with each other.

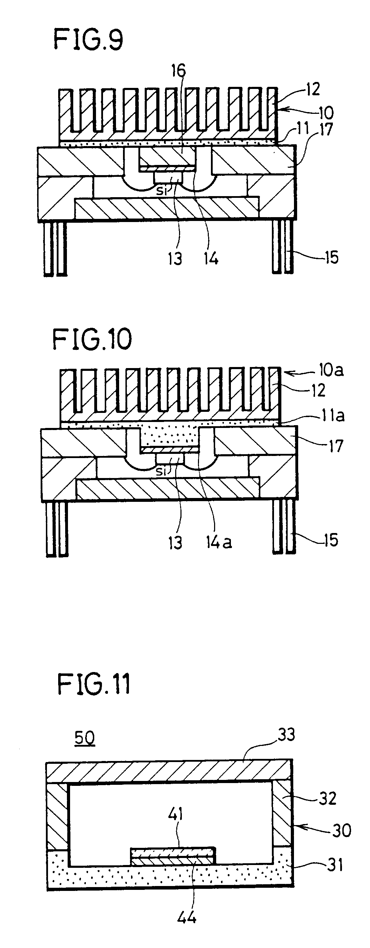

Fig. 2 shows a radiation member 10, which is formed by the low thermal expansion aluminum alloy member 12 integrated with the same. Fig. 9 shows an exemplary IC package, to which this radiation member 10 is applied. Fig. 9 is a sectional view showing the exemplary IC package, into which the inventive radiation member 10 is integrated. Referring to Fig. 9, a semiconductor element 13 is joined to a copper-tungsten alloy substrate 16 through a solder member 14. The radiation member 10 is integrally joined with the copper-tungsten alloy substrate 16. This radiation member 10 is mounted on an upper surface of an envelope member 17 which is formed of a ceramic material such as alumina. Numeral 15 denotes Kovar wires which serve as extraction terminals.

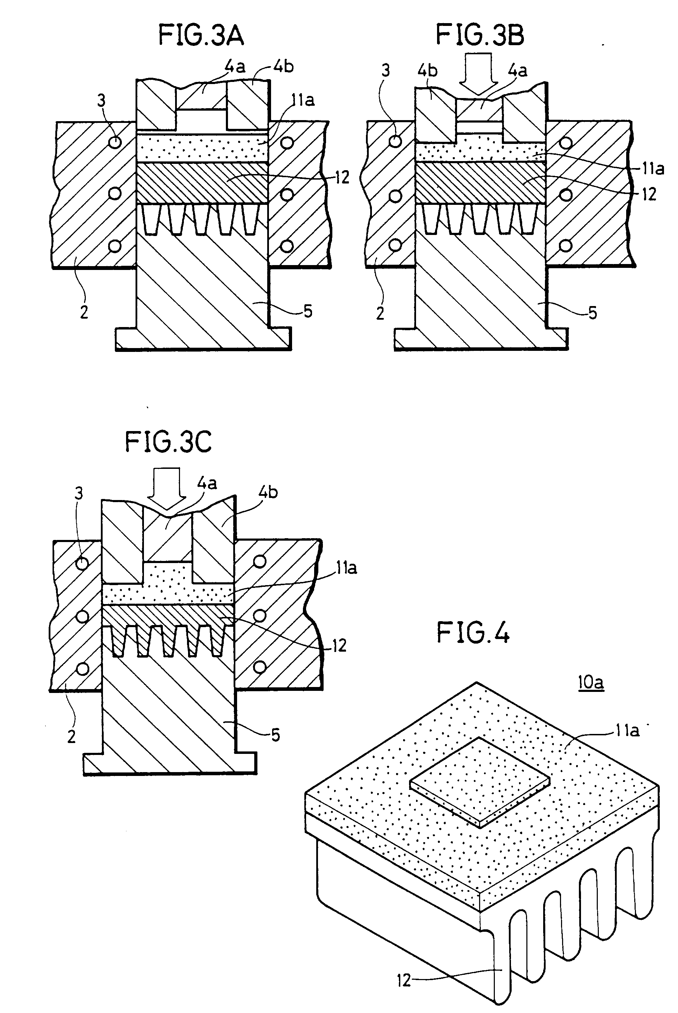

Figs. 3A, 3B and 3C are partially fragmented sectional views showing another exemplary method of manufacturing a radiation member according to the present invention. Similarly to the method shown in Figs. 1A and 1B, a high radiation aluminum alloy member 12 and a low thermal expansion aluminum alloy member 11a are introduced into a clearance defined between dies 2, which are heated by heating elements 3, a lower punch 5 and upper punches 4a and 4b. Thereafter the low thermal expansion aluminum alloy member lla and the high radiation aluminum alloy member 12 are pressurized/formed along the arrow shown in Figs. 3B and 3C, to provide a radiation member by integration of the aluminum alloy members 11a and 12.

Fig. 4 shows a radiation member 10a thus obtained. Fig. 10 is a sectional view showing an exemplary IC package to which the radiation member 10a is applied. According to this figure, a semiconductor element 13 is directly joined to the low thermal expansion aluminum alloy member 11a of the radiation member 10a by a sealant material 14a such as Ag paste, dissimilarly to the IC package shown in Fig. 9. Other structure of this IC package is similar to that of the example shown in Fig. 9.

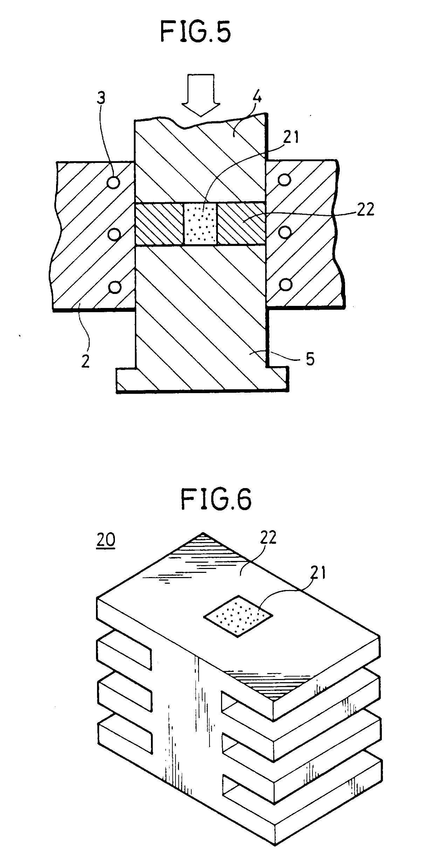

Fig. 5 is a partially fragmented sectional view showing still another exemplary method of manufacturing a radiation member according to the present invention. Referring to Fig. 5, a high radiation aluminum alloy member 22 prepared from a metal plate having a central hole, which is formed of the aluminum alloy of JIS or ASTM nominal No. 1100, for example, is forced into a clearance defined between dies 2, which are heated by heating elements 3, and a lower punch 5, similarly to the manufacturing method shown in Fig. 1. A low thermal expansion aluminum alloy member 21 prepared from quench-solidified powder of an aluminum alloy composed of Al - 40 wt.% Si is charged in the central hole. Thereafter the aluminum alloy members 21 and 22 are pressurized along the arrow shown in this figure by an upper punch 4 and the lower punch 5, to be pressurized/formed. A formed body of the aluminum alloys thus obtained is subjected to machine work, so that its outer peripheral portions are formed into radiation fins. Fig. 6 shows a radiation member 20 thus obtained. Also this radiation member 20 can be integrated into an IC package.

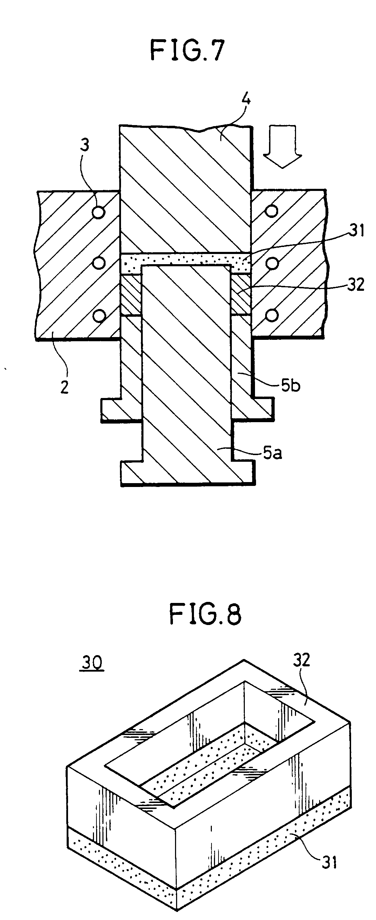

Fig. 7 is a partially fragmented sectional view showing a further exemplary method of manufacturing a radiation member according to the present invention. Referring to Fig. 7, a high radiation aluminum alloy member 32 formed by a frame of the aluminum alloy of JIS or ASTM nominal No. 1100, for example, is forced into a clearance defined between dies 2, which are heated by heating elements 3, and lower punches 5a and 5b. Further, a low thermal expansion aluminum alloy 31 of quench-solidified powder composed of Al - 40 wt.% Si is charged in a clearance which is defined between the lower punch 5a and an upper punch 4. Thereafter the aluminum alloy members 31 and 32 are pressurized/formed by the upper and lower punches 4, 5a and 5b along the arrow shown in the figure, so that the aluminum alloy members 31 and 32 are integrated with each other by diffused junction to define a box. Fig. 8 shows a box-type radiation member 30 thus formed. Such a radiation member 30 is applied to a case of a package for a microwave integrated circuit device which is employed in the field of an artificial, satellite, an aircraft and the like, i.e., a case of a metal package.

Fig. 11 is a sectional view showing the structure of a metal package 50 which is formed through the box-type radiation member 30 shown in Fig. 8. Referring to Fig. 11, an alumina circuit substrate 41 for a microwave integrated circuit device is joined onto the inner bottom surface of the box-type radiation member 30, which is formed by the low thermal expansion aluminum alloy member 31 and the high radiation aluminum alloy member 32 joined thereto, i.e., onto the surface of a portion formed by the low thermal expansion aluminum alloy member 31, through an Au-Sn solder member 44. An opening part of this radiation member 30 is closed by a lid member 33 of a JIS nominal high radiation aluminum alloy, for example, which is joined to the radiation member 30 through laser welding.

Although the low thermal expansion aluminum alloy is composed of Al - 40 wt.% Si in each of the above embodiments, the composition of the aluminum alloy is not restricted to this. For example, the low thermal expansion aluminum alloy may be prepared from Al-Si alloys containing 30 to 60 percent by weight of silicon and having composition ratios shown in Table 1.

Table 1 also shows thermal expansion coefficients and values of density and thermal conductivity of aluminum alloy members which are formed by performing hot plastic working on quench-solidified powder prepared by adding 30 to 60 percent by weight of silicon to aluminum. Table 1 further shows values of Al-Si alloys containing 25 percent by weight and 65 percent by weight of silicon respectively, for the purpose of reference.

**Table 1**

| Composition Al-Si (wt.%) | Density (g/cm³) | Thermal Expansion Coefficient (x10⁻⁶/°C) | Thermal Conductivity (cal/°C·cm·sec) |
|---|---|---|---|
| Al-25Si | 2.60 | 17.4 | 0.38 |
| 30Si | 2.58 | 16.5 | 0.35 |
| 40Si | 2.53 | 13.5 | 0.30 |
| 50Si | 2.50 | 11.2 | 0.27 |
| 60Si | 2.43 | 9.8 | 0.25 |
| 65Si | 2.41 | 8.8 | 0.24 |

1 Cal = 4.184J

Although the high radiation aluminum alloy is prepared from the aluminum alloy of JIS or ASTM nominal No. 1100 in each of the above embodiments, the material therefor is not restricted to this. For example, the high radiation aluminum alloy may be prepared from any aluminum alloy shown in Table 2. Further, although the high radiation aluminum alloy member is formed by an aluminum alloy plate in each of the above embodiments, the same may be formed from powder of the same composition.

Further, although the low thermal expansion aluminum alloy is prepared from the Al-Si alloy in the embodiments of the present invention, the same may be prepared by adding carbon to aluminum thereby to reduce the thermal expansion coefficient.

The high radiation aluminum alloys listed in Table 2 are excellent in machinability, whereby the working cost can be reduced also when machine work is required, while the radiation member can be formed into a complex configuration.

**Table 2**

| Type of Aluminum Alloy (JIS/ASTM Nominal No.) | Thermal Conductivity (25°C)(Cal/°C·cm·sec) |
|---|---|
| 1060 | 0.56 |
| 1100 | 0.53 |
| 1200 | 0.52 |
| 2011 | 0.41 |
| 2014 | 0.46 |
| 2017 | 0.46 |
| 2024 | 0.46 |
| 2219 | 0.41 |
| 3003 | 0.46 |
| 3105 | 0.41 |
| 5005 | 0.48 |
| 5050 | 0.46 |
| 6061 | 0.43 |
| 6N01 | 0.51 |
| 6063 | 0.50 |
| 6151 | 0.52 |
| 7072 | 0.53 |

1 Cal = 4.184J.

According to Table 1, the thermal expansion coefficient exceeds a desired value when the content of silicon is less than 30 percent by weight, and hence it is difficult to directly mount a circuit substrate. When the content of silicon exceeds 60 percent by weight, on the other hand, thermal conductivity is so reduced that desired heat dissipation cannot be attained while machinability is deteriorated because of increase in hardness. According to the present invention, therefore, the silicon content of the aluminum alloy employed for a container member forming a package for a microwave integrated circuit device is limited within the range of 30 to 60 percent by weight.

Table 3 shows the density, the Young's modulus and specific rigidity of the exemplary aluminum alloy of Al - 40 wt.% Si forming the inventive container member with those of stainless steel and the aluminum alloy of JIS nominal No. 1100 for reference.

**Table 3**

| Material | Density (g/cm³) | Young's Modulus (Kgf/mm) | Specific Rigidity (x10⁶mm) |
|---|---|---|---|
| Stainless Steel | 8.0 | 20,000 | 2,500 |
| Al Alloy (JIS1100) | 2.7 | 7,200 | 2,666 |
| Al-40wt.%Si | 2.53 | 10,300 | 4,071 |

According to Table 3, the aluminum alloy composed of Al - 40 wt.% Si has a Young's modulus of 10300 kgf/mm under the room temperature, which value is higher by at least 40 % than that of 7200 kgf/mm of the aluminum alloy of JIS or ASTM nominal No. 1100 listed as an example of a general aluminum alloy. Thus, it is possible to reduce the thickness of a case or a lid forming a package by employing the Al - 40 wt.% Si alloy as compared with the package formed of the general aluminum alloy.

The exemplary general aluminum alloy of JIS nominal No. 1100 is smaller in specific gravity than stainless steel which is listed as an exemplary ferrous material, while the former is not substantially different from the latter in specific rigidity since the Young's modulus thereof is small. In a package of the general aluminum alloy, therefore, a case, a lid and the like forming the package are inevitably increased in thickness and hence the characteristics of the aluminum alloy cannot contribute to reduction in size and weight of the package. On the other hand, when the Al - 40 wt.% Si alloy having specific rigidity 1.6 times that of stainless steel is applied to a package material, for example, the total weight of the package can be reduced by about 40 % as compared with that of stainless steel, although the thickness thereof is slightly increased as compared with that of the stainless steel package.

According to the present invention, primary silicon crystal contained in the aluminum alloy which is applied to the container member forming the package for a microwave integrated circuit device is preferably not more than 50 µm in particle size. If the particle size of primary silicon crystal exceeds 50 µm, machinability is deteriorated while pinholes, nonuniformity etc. are caused in surface treatment.

Examples of the package for a microwave integrated circuit device are now described. Example 1

Powder of an Al - 40 wt.% Si alloy was prepared by a gas atomizing method at an average cooling rate of at least 10 K/sec., so that the alloy powder was not more than 42 mesh. The average particle size of silicon crystal contained in the powder thus obtained was not more than 50 µm.

Thereafter the powder was heated to a temperature of at least 500°C, and formed into a plate member by extrusion. This plate member was 2.53 g/cm³ in density, 13.3 x 10⁻⁶/°C in thermal expansion coefficient and 1.26 J/°C·cm·sec (0.3 cal/°C·cm·sec.) in thermal conductivity.

A microwave integrated circuit substrate of Al₂O₃, on which a semiconductor element was mounted, was adhered to the plate member of the Al - 40 wt.% Si alloy thus obtained through Au-Sn solder. The joined plane of the circuit substrate was tungsten-metallized at this time. Table 4 shows the sizes of samples of the Al₂O₃ substrate thus joined. Samples of a similar Al₂O₃ substrate were joined to plate members of an aluminum alloy of JIS or ASTM nominal No. 5052 for reference. Table 4 also shows the result of a heat cycle test made on each sample thus prepared in a temperature range of -65 to 150°C for 100 cycles. According to Table 4, no defect such as separation was recognized between the microwave integrated circuit substrate and the plate member of the aluminum alloy composed.

**Table 4**

| Sample | Size of Al₂O₃ Substrate (mm) x (mm) | | |
|---|---|---|---|
| | 8 x 16 | 16 x24 | 24 x 32 |
| Al-40wt.%Si | O | O | O |
| Al Alloy (JIS 5052) | X | X | X |

- O:: No Defect
- X:: Separated After Soldering

### Example 2

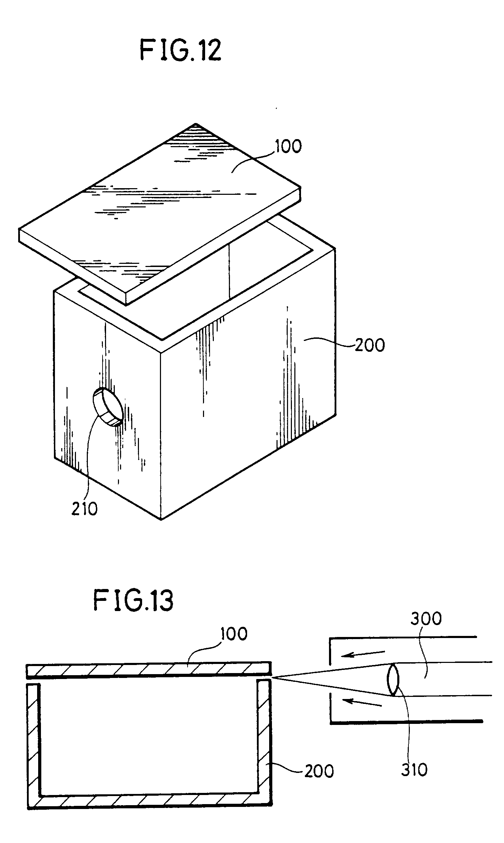

The plate member of the Al - 40 wt.% Si alloy obtained in Example 1 was empljed for manufacturing a package shown in Fig. 12 which is included herein for illustrative purposes, which was formed by a lid 100 and a case 200. The case 200 was provided with a hole 210 for a lead terminal, and a microwave integrated circuit substrate (not shown) was mounted within the case 200.

Fig. 13 shows a method of laser welding employed for manufacturing the package. Referring to Fig. 13, a laser beam 300 condensed by a lens 310 was applied between the case 200 and the lid 100. At this time, argon gas was supplied as shown by arrows, to serve as sealing gas.

The lid 100 and the case 200 were joined with each other by the method shown in Fig. 13. The laser beam 300 was emitted from a YAG pulser laser in an average output of 100 to 200 W, with pulse width of 5 to 9 msec. at a pulse rate of 15 to 20 p/sec. Laser welding was performed at a welding speed of 80 to 130 mm/min.

The package thus obtained had high strength and fine structure, since the lid 100 and the case 200 were prepared from quench-solidified powder. Thus, the base metal and the weld zone were merely slightly changed in structure by quench solidification after the laser welding, while no cracking was caused and no blowholes were recognized. Then, airtightness of the package was examined by a helium leakage test, to recognize that airtightness of about 1.2 x 10⁻¹⁰ cc/sec. was maintained after a heat cycle test performed within a temperature range of -65 to 150°C for 100 cycles. Further, a shear fracture test was performed in order to examine strength of the junction between the lid 100 and the case 200. The shearing force thus measured was at least 100 kg, a value which was sufficient in handling of the package.

Although the aluminum alloy forming the lid and the case was composed of an Al - 30 to 60 wt.% Si alloy in each of the above Examples, at least only the case serving as a container member for the package may be prepared from the Al-Si alloy having the aforementioned composition, and the lid member may be prepared from a general aluminum alloy according to JIS or ASTM.

As hereinabove described, the present invention can provide a radiation member of aluminum alloys for a semiconductor device which has both characteristics of low thermal expansion and high heat dissipation.

## Claims

1. Radiation member (10;20;30) for a semiconductor device, comprising:
a mounting section (11;21;31) made of a first aluminum alloy having a major surface for carrying said semiconductor device thereon, said first aluminum alloy having an average thermal expansion coefficient of not more than 17 x 10⁻⁶/°C; and
a heat sink section (12;22;32) made of a second aluminum alloy having a thermal conductivity of at least 1.72 J/°C·cm·sec (0.41 cal/°C·cm·sec), being larger in thermal conductivity than said first aluminum alloy, wherein
said first aluminum alloy contains 30 to 60 percent by weight of silicon; and
said mounting section (11; 21; 31) being diffusion-bonded to said head sink section (12;22;32) thereby integrally joining the mounting section and the heat sink section with each other by a diffused junction.

2. Radiation member (10) for a semiconductor device in accordance with claim 1, wherein said heat sink section (12) of said second aluminum alloy includes parts which are formed into fins.

3. Radiation member (10a) for a semiconductor device in accordance with any of the preceding claims, wherein said mounting section (11a) of said first aluminum alloy includes a raised portion.

4. Radiation member (20) for a semiconductor device in accordance with any of the preceding claims, wherein said mounting section (21) of said first aluminum alloy is filled in a hole formed in said heat sink section (22) of said second aluminum alloy to be integrally joint to said heat sink section of said second aluminum alloy.

5. Radiation member (30) for a semiconductor device in accordance with claim 1, wherein the mounting section forms a bottom wall portion (31) having an inner surface for carrying a microwave integrated circuit device thereon, and the heat sink section forms a frame portion (32) comprising a side wall part integrally joined to said bottom wall portion.

## Patentansprüche

1. Wärmeabstrahlungsbauteil (10; 20; 30) für eine Halbleiteranordnung umfassend:
ein Trägerteil (11; 21; 31), das aus einer ersten Aluminiumlegierung hergestellt ist und das eine Hauptoberfläche zum Tragen der Halbleiteranordnung aufweist, wobei die erste Aluminiumlegierung einen durchschnittlichen Wärmeausdehnungskoeffizienten von nicht mehr als 17x10⁻⁶/°C hat; und
ein Wärmesenkenteil (12; 22; 32), das aus einer zweiten Aluminiumlegierung hergestellt ist, die eine thermische Leitfähigkeit von mindestens 1.72 Joule/°C cm sec (0.41 cal/°C cm sec) aufweist, wobei die Wärmeleitfähigkeit größer ist als bei der ersten Aluminiumlegierung, worin erste Aluminiumlegierung 30 - 60 Gewichtsprozent an Silizium enthält; und
das Trägerteil (11; 21; 31) mit dem Wärmesenkenteil (12; 22; 32) durch Difussion verbunden ist, wodurch das Trägerteil und das Wärmesenkenteil durch eine Diffusionsverbindung einstückig miteinander verbunden sind.

2. Wärmeabstrahlungsbauteil (10) für eine Halbleiteranordnung nach Anspruch 1, worin das Wärmesenkenteil (12) der zweiten Aluminiumlegierung Teile beinhaltet, welche als Kühlrippen geformt sind.

3. Wärmeabstrahlungsbauteil (10a) für eine Halbleiteranordnung nach einem der vorangegangenen Ansprüche, worin das Trägerteil (11a) der ersten Aluminiumlegierung ein erhöhtes Teilstück beinhaltet.

4. Wärmeabstrahlungsbauteil (20) für eine Halbleiteranordnung nach einem der vorangegangenen Ansprüche, worin das Trägerteil (21) der ersten Aluminiumlegierung in ein Loch, das in dem Wärmesenkenteil (22) der zweiten Aluminiumlegierung geformt ist eingesetzt wird, um einstückig mit dem Wärmesenkenteil der zweiten Aluminiumlegierung verbunden zu sein.

5. Wärmeabstrahlungsbauteil (30) für eine Halbleiteranordnung nach Anspruch 1, worin das Trägerteil einen Bodenwandabschnitt (31) bildet, der eine Innenoberfläche zum Tragen einer Mikrowellen-IC-Schaltungseinrichtung aufweist, und das Wärmesenkenteil ein Rahmenteil (32) bildet, das ein Seitenwandteil umfaßt, das einstückig mit dem Bodenwandabschnitt verbunden ist.

## Revendications

1. Elément de radiation (10; 20; 30) destiné à un dispositif à semi-conducteurs comprenant :
une section de montage (11; 21; 31) réalisée à partir d'un premier alliage en aluminium avec une surface principale pour supporter le dispositif à semi-conducteurs, le premier alliage d'aluminium ayant un coefficient de dilatation thermique moyen ne dépassant pas 17 x 10⁻⁶/°C ; et
une section de dissipateur thermique (12; 22; 32) réalisée à partir d'un second alliage d'aluminium ayant une conductivité thermique d'au moins 1,72 J/°C.cm.sec (0,41 cal/°C.cm.sec), de conductivité thermique supérieure au premier alliage d'aluminium, dans lequel
le premier alliage d'aluminium contient 30 à 60 % en poids de silicium ; et
la section de montage (11; 21; 31) étant soudée par diffusion sur la section de dissipateur thermique (12; 22; 32) permettant ainsi de souder solidairement la section de montage et la section de dissipateur thermique par une couche de jonction diffuse.

2. Elément de radiation (10) destiné à un dispositif à semi-conducteurs selon la revendication 1, dans lequel la section de dissipateur thermique (12) du second alliage d'aluminium comprend des parties qui sont formées en ailettes.

3. Elément de radiation (10a) destiné à un dispositif à semi-conducteurs selon l'une quelconque des revendications précédentes, dans lequel la section de montage (11a) du premier alliage d'aluminium comprend une portion relevée.

4. Elément de radiation (20) destiné à un dispositif à semi-conducteurs selon l'une quelconque des revendications précédentes, dans lequel la section de montage (21) du premier alliage d'aluminium est garnie dans un trou ménagé dans la section du dissipateur thermique (22) du second alliage d'aluminium à souder solidairement avec la section de dissipateur thermique du second alliage d'aluminium.

5. Elément de radiation (30) destiné à un dispositif à semi-conducteurs selon la revendication 1, dans lequel la section de montage forme une portion de paroi de fond (31) avec une surface interne destinée à supporter un dispositif à circuit intégré à micro-ondes et la section de dissipateur thermique forme une portion de châssis (32) comprenant une partie de paroi latérale soudée solidairement à la portion de paroi de fond.
